# FASCICULE DE BREVET EUROPEEN

(11) **EP 1 242 971 B1**
(45) Date de publication et mention de la délivrance du brevet: **08.10.2003**
(21) Numéro de dépôt: 00985420.9
(22) Date de dépôt: 13.12.2000
(51) Int. Cl.: G06K 19/077

(54) **ELEMENT DE CARTE A CIRCUIT INTEGRE MONTE EN FLIP-CHIP**
FLIP CHIP MONTAGE EINES IC-KARTENELEMENTS
FLIP-CHIP MOUNTED INTEGRATED CIRCUIT CARD ELEMENT

(30) Priorité: 30.12.1999 FR 9916736
(43) Date de publication de la demande: 25.09.2002
(73) Titulaire: SCHLUMBERGER Systèmes, 92120 Montrouge (FR)
(72) Inventeur: GIRARD, Sophie, F-45100 Orléans Cedex (FR); PROVOST, Stéphane, F-45800 Saint Jean de Braye (FR)
(86) Numéro de dépôt international: FR0003500
(87) Numéro de publication internationale: WO01050415

(56) Documents cités:
- FR-A- 2 756 955
- US-A- 5 528 222
- US-A- 5 682 296

## Description

La présente invention concerne un élément de carte à circuit intégré monté en flip-chip.

On sait qu'en raison du développement toujours croissant des applications utilisant un circuit intégré il est nécessaire de réaliser un nombre de plus en plus important d'éléments de carte comportant un circuit intégré. Afin de satisfaire à la demande il est donc nécessaire d'utiliser un procédé permettant une fixation très rapide d'un circuit intégré sur un élément de carte. A cet effet on réalise un montage du circuit intégré en flip-chip c'est-à-dire que la face active du circuit intégré sur laquelle débouchent les plots de connexion du circuit intégré est appliquée directement sur les bornes d'un circuit électrique réalisé préalablement sur un support. Le circuit intégré est en outre fixé sur le support par une résine de scellement disposée entre la face active du circuit intégré et le support.

Le brevet US 5 682 296 reflétant le preambule de la revendication 1 concerne une carte comprenant un module de circuit intégré dans laquelle est introduit un élément de renforcement entourant le module afin de le protéger. L'élément de renforcement est inséré dans une ou plusieurs couches de la carte. L'élément de renforcement permet de diminuer les efforts qui portent sur le circuit intégré lors de flexions et de torsions de la carte. Néanmoins un tel élément de renforcement ne permet pas de protéger la face active du circuit intégré en particulier lors du processus de fabrication.

Dans les techniques de fabrications actuelles des éléments de carte, en particulier lorsque l'élément de carte est destiné à constituer une partie d'une carte utilisée dans un terminal électronique, qu'il s'agisse d'une carte avec contact ou sans contact, le support du circuit intégré est généralement fin ou flexible et il existe donc un risque de détérioration du circuit intégré lorsque l'élément de carte est soumis à des contraintes mécaniques, par exemple des contraintes en flexion ou en torsion. A ce propos les différents traitements et les différentes manipulations auxquels le circuit intégré est soumis lors de sa fabrication et de sa mise en place sur l'élément de carte risquent de provoquer dans la face inactive du circuit intégré, qui est opposée à la face active, des amorces de rupture qui diminuent la résistance à la flexion du circuit intégré.

Pour pallier cet inconvénient on propose selon l'invention un élément de carte à circuit intégré comportant un support sur lequel est réalisé un circuit électrique auquel est associé un circuit intégré ayant une face active montée en flip-chip, le circuit intégré étant fixé au support par un produit de scellement disposé entre la face active du circuit intégré et le support, dans lequel une pastille de renfort est fixée sur une face inactive du circuit intégré opposée à la face active.

Ainsi la pastille de renfort assure non seulement une augmentation de la résistance mécanique de la face inactive du circuit intégré mais surtout elle provoque un déplacement de la fibre neutre de l'élèvement de carte vers la pastille de renfort de sorte que la face inactive du circuit intégré est soumise à des contraintes moins importantes en traction ou en compression lors d'une flexion de l'élément de carte. Le risque de rupture du circuit intégré est donc doublement minimisé.

Selon une version avantageuse de l'invention le produit de scellement entoure le circuit intégré et est de préférence en contact avec un bord de la pastille de renfort. Ainsi le produit de scellement réalise un encastrement autour du circuit intégré et de la pastille de renfort.

Selon une autre version avantageuse de l'invention le produit de scellement recouvre la pastille de renfort. Le circuit intégré et la pastille de renfort sont ainsi encapsulés dans le produit de scellement.

D'autres caractéristiques et avantages de l'invention apparaîtront à la lecture de la description qui suit de trois modes de réalisation particuliers non limitatifs de l'élément de carte à circuit intégré selon l'invention en référence aux figures ci-jointes parmi lesquelles:
- la figure 1 est une vue en coupe d'une partie d'un élément de carte sans contact selon un premier mode de réalisation de l'invention,
- la figure 2 est une vue en coupe analogue à celle de la figure 1 selon un deuxième mode de réalisation de l'invention,
- la figure 3 est une vue en coupe analogue à celle de la figure 1 d'un troisième mode de réalisation de l'invention.

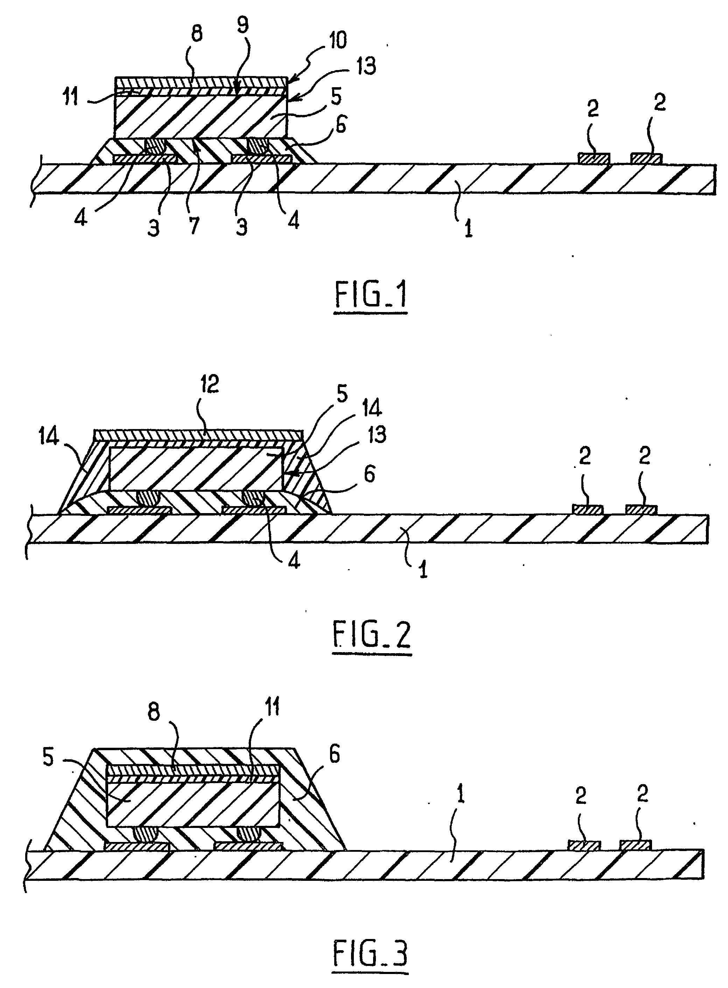

En référence à la figure 1, l'élément de carte à circuit intégré selon l'invention comporte de façon connue en soi un support 1, par exemple une feuille de matière thermoplastique, sur lequel a été réalisé un circuit électrique 2, ici un circuit d'antenne dont deux spires seulement ont été représentées sur la figure. Le circuit électrique 2 comporte des bornes 3 auxquelles sont connectés des plots 4 d'un circuit intégré 5 fixé au support 1 par une résine de scellement 6 disposée entre la face active 7 du circuit intégré et la partie en regard du support 1.

Selon l'invention une pastille de renfort 8 est fixée sur la face inactive 9 du circuit intégré. La pastille de renfort 8 peut être réalisée en tout matériau approprié pour assurer un renfort correspondant à la nature du circuit intégré et à l'utilisation de l'élément de carte. En particulier la pastille de renfort peut être réalisée en matériau composite, en matière plastique, ou en métal comme illustré. Sa structure peut être homogène ou hétérogène. Dans ce mode de réalisation, la mise en place de la pastille est effectuée par mise en place d'une feuille de renfort sur une galette de circuits intégrés puis découpage simultané de la galette et de la feuille de renfort de sorte que le bord 10 de la pastille de renfort 8 s'étend à l'aplomb de la surface latérale 13 du circuit intégré 5.

La fixation de la pastille de renfort sur la face inactive du circuit intégré peut être de même nature que le scellement du circuit intégré sur le support. En particulier elle peut être réalisée par une colle ou une résine 11 déposée sur la pastille et/ou sur la face inactive du circuit intégré à chaud ou à froid et optionnellement activable à chaud ou à froid.

L'épaisseur et la nature de la pastille ainsi que l'épaisseur et la nature de la résine ou colle 11 fixant la pastille 8 sur le circuit intégré 5 sont choisies en fonction de l'application pour assurer un déplacement approprié de la fibre neutre des contraintes lors d'une flexion de l'élément de carte.

Dans le second mode de réalisation illustré dans par la figure 2 le montage du circuit intégré est réalisé de la même façon que précédemment mais la pastille de renfort 12 a des dimensions supérieures à la face supérieure du circuit intégré 6 et est fixée à celle-ci après montage du circuit intégré 5 sur le support 1. Pour la fixation de la pastille de renfort 12 on effectue par exemple le dépôt d'une goutte de résine 14 sur la face supérieure du circuit intégré puis on applique la pastille de renfort 12. La résine 14 se répand entre la pastille 12 et la surface supérieure du circuit intégré 5 et s'écoule sur les côtés de celui-ci pour rejoindre la résine de scellement 6. La surface latérale 13 du circuit intégré est ainsi surplombée par la pastille de renfort 12 et entourée par la résine 14 de sorte que la pastille 12 est fixée d'une façon plus forte que dans le premier mode de réalisation.

Dans le troisième mode de réalisation illustré par la figure 3 la résine de scellement 6 recouvre la pastille de renfort 8 de sorte que le circuit intégré 5 et la pastille de renfort 8 sont encapsulés dans la résine de scellement. Dans ce mode de réalisation on peut également prévoir de déposer la résine de scellement de façon à simplement entourer le circuit intégré sans recouvrir celui-ci tout en venant en contact avec le bord 10 de la pastille de renfort de sorte que le circuit intégré 5 et la pastille de renfort 8 sont encastrés dans la résine de scellement 6.

Bien entendu l'invention n'est pas limitée aux modes de réalisation décrits et est susceptible de variantes de réalisation qui apparaîtront à l'homme de métier sans sortir du cadre de l'invention tel que défini par les revendications.

En particulier bien que la pastille de renfort ait été représentée avec un bord 10 à l'aplomb de la surface latérale du circuit intégré ou en surplomb par rapport à celle-ci on peut prévoir une pastille de renfort dont le bord 10 est en retrait par rapport à la face latérale du circuit intégré 5 ou ayant une forme différente de la forme du circuit intégré.

En fonction des conditions d'utilisation de l'élément de carte à circuit intégré selon l'invention on pourra en outre faire varier l'épaisseur de la pastille de renfort, la nature du matériau qui la compose ou l'épaisseur de la résine de fixation comprise entre la face inactive du circuit intégré et la pastille de renfort.

Bien que l'invention ait été décrite en relation avec un élément de carte sans contact, elle peut être également mise en oeuvre sur un élément de carte destiné à être intégré à une carte avec contacts.

Bien que l'invention ait été décrite en relation avec une résine de scellement déposée autour du circuit intégré après un positionnement de celui-ci sur le support, on peut également réaliser l'invention en utilisant un autre produit de scellement, par exemple un film en matière réactivable contenant des particules électroconductrices qui la rendent anisotropique électriquement et permettent de rendre le produit de scellement conducteur à l'aplomb des bornes du circuit intégré. Le produit de scellement est alors mis en place sur la face active du circuit intégré avant la mise en place de celui-ci sur le support, voire même avant de scier la galette de silicium sur laquelle le circuit intégré est initialement réalisé.

## Revendications

1. Élément de carte à circuit intégré comportant un support (1) sur lequel est réalisé un circuit électrique (2) auquel est associé un circuit intégré (5) ayant une face active (7) monté en flip-chip, le circuit intégré (5) étant fixé au support par un produit de scellement (6) disposé entre la face active du circuit intégré et le support, l'élément de carte à circuit intégré comprenant en outre une pastille de renfort et étant **caractérisé en ce que** ladite pastille de renfort(8, 12) est fixée sur une face inactive (9) du circuit intégré opposée à la face active (7).

2. Élément de carte selon la revendication 1, **caractérisé en ce que** le produit de scellement (6) entoure le circuit intégré (5).

3. Elément de carte selon la revendication 2, **caractérisé en ce que** le produit de scellement est en contact avec un bord (10) de la pastille de renfort (8).

4. Élément de carte selon la revendication 3, **caractérisé en ce que** le produit de scellement (6) recouvre la pastille de renfort (8).

5. Élément de carte selon la revendication 1, **caractérisé en ce que** le circuit intégré (5) a une face latérale (13) qui est surplombée par la pastille de renfort (12) et **en ce que** la pastille de renfort (12) est fixée par une résine (14) qui s'étend entre la pastille de renfort et la face inactive (9) du circuit intégré (5) et autour de la face latérale (13).

## Patentansprüche

1. Kartenelement mit integriertem Schaltkreis, das einen Träger (1) umfasst, auf dem ein Stromkreis (2) erstellt wird, der mit einem integrierten Schaltkreis (5) mit einer als Flip-Chip montierten aktiven Seite (7) in Verbindung steht, wobei der integrierte Schaltkreis (5) durch ein Eingussmittel (6), das zwischen der aktiven Seite des integrierten Schaltkreises und dem Träger angebracht ist, auf den Träger fixiert wird, und das Kartenelement mit integriertem Schaltkreis zudem ein Verstärkungsplättchen umfasst, **dadurch gekennzeichnet, dass** das Verstärkungsplättchen (8, 12) auf einer der aktiven Seite (7) gegenüberliegenden inaktiven Seite (9) des integrierten Schaltkreises fixiert wird.

2. Kartenelement gemäß Anspruch 1, **dadurch gekennzeichnet, dass** das Eingussmittel (6) den integrierten Schaltkreis (5) umgibt.

3. Kartenelement gemäß Anspruch 2, **dadurch gekennzeichnet, dass** das Eingussmittel den Rand (10) des Verstärkungsplättchens (8) berührt.

4. Kartenelement gemäß Anspruch 3, **dadurch gekennzeichnet, dass** das Eingussmittel (6) das Verstärkungsplättchen (8) abdeckt.

5. Kartenelement gemäß Anspruch 1, **dadurch gekennzeichnet, dass** der integrierte Schaltkreis (5) eine Seitenfläche (13) hat, über die das Verstärkungsplättchen (12) übersteht und dass das Verstärkungsplättchen (12) mit Harz (14) fixiert ist, das sich zwischen dem Verstärkungsplättchen und der inaktiven Seite (9) des integrierten Schaltkreises (5) und um die Seitenfläche (13) herum erstreckt.

## Claims

1. Card element with an integrated circuit including a support (1) with an electrical circuit (2) to which is associated an integrated circuit (5) which has an active side (7) mounted using the flip-chip technique, the integrated circuit (5) being bonded to the support by a sealing product (6) applied between the active side of the integrated circuit and the support, the card element with an integrated circuit further comprising a reinforcement disc (8, 12) **characterised in that** the reinforcement disc (8, 12) is bonded on an inactive side (9) of the integrated circuit opposite the active side (7).

2. Card element according to claim 1, **characterised in that** the sealing product (6) surrounds the integrated circuit (5).

3. Card element according to claim 2, **characterised in that** the sealing product is in contact with an edge (10) of the reinforcement disc (8).

4. Card element according to claim 3, **characterised in that** the sealing product (6) covers the reinforcement disc (8).

5. Card element according to claim 1, **characterised in that** the integrated circuit (5) has a lateral side (13) which is underneath the reinforcement disc (12) and **in that** the reinforcement disc (12) is bonded by a resin (14) spread between the reinforcement disc and the inactive side (9) of the integrated circuit (5) and running over the lateral side (13).
